(19) Europäisches Patentamt / European Patent Office / Office européen des brevets

(11) **EP 2 137 913 B1**

(12) **FASCICULE DE BREVET EUROPEEN**

(45) Date de publication et mention
de la délivrance du brevet:
**10.10.2012 Bulletin 2012/41**

(21) Numéro de dépôt: **08788033.2**

(22) Date de dépôt: **21.03.2008**

(51) Int Cl.:
***H04L 25/02*** *(2006.01)*    ***H01L 43/08*** *(2006.01)*

(86) Numéro de dépôt international:
**PCT/FR2008/050506**

(87) Numéro de publication internationale:
**WO 2008/132398 (06.11.2008 Gazette 2008/45)**

(54) **DISPOSITIF ÉLECTRONIQUE POUR LE TRANSPORT D'INFORMATIONS NUMÉRIQUES**

ELEKTRONISCHE VORRICHTUNG ZUR BEFÖRDERUNG VON DIGITALER INFORMATION

ELECTRONIC DEVICE FOR CONVEYING DIGITAL INFORMATION

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **23.03.2007 FR 0754004**

(43) Date de publication de la demande:
**30.12.2009 Bulletin 2009/53**

(73) Titulaires:
- **Commissariat à l'Énergie Atomique
  et aux Énergies Alternatives
  75015 Paris (FR)**
- **Centre National de la Recherche Scientifique
  75794 Paris Cedex 16 (FR)**

(72) Inventeur: **JAVERLIAC, Virgile**
**F-38370 St Prim (FR)**

(74) Mandataire: **Vuillermoz, Bruno et al
Cabinet Laurent & Charras
"Le Contemporain"
50, Chemin de la Bruyère
69574 Dardilly Cédex (FR)**

(56) Documents cités:
**EP-A- 0 093 870        WO-A-01/25803
WO-A-99/21332        WO-A-03/088283
US-A- 5 783 284        US-A- 6 087 882
US-A1- 2005 026 307**

**Description**

**DOMAINE TECHNIQUE**

La présente invention concerne un dispositif électronique pour le transport d'informations numériques sur longues distances, comprenant un émetteur associé à un récepteur magnétorésistif. Par informations numériques on entend des « 0 » et des «1», également dénommés informations ou signaux logiques par opposition aux signaux analogiques.

La présente invention se rapporte donc au domaine des infrastructures informatiques destinées à la transmission rapide de données entre composants voisins ou distants, au moyen de connections à fils ou lignes.

Par composants voisins on désigne des composants appartenant à une même carte électronique, tandis que les composants distants désignent par exemple deux périphériques plus ou moins éloignés comme la carte graphique et l'écran d'un micro-ordinateur.

**ETAT ANTERIEUR DE LA TECHNIQUE**

Dans le domaine de la microélectronique, on réalise actuellement des processeurs dont les fréquences de fonctionnement sont de plus en plus élevées, s'étalant typiquement de quelques GHz à une vingtaine de GHz pour certains prototypes. Une telle amélioration des performances des microprocesseurs permet de traiter des informations numériques de plus en plus rapidement et donc de résoudre des algorithmes de plus en plus complexes en un temps de plus en plus court.

C'est pourquoi on cherche également à développer des dispositifs émetteurs-récepteurs aptes à transporter ces informations numériques à des vitesses de plus en plus élevées afin de suivre les cadences de traitement des microprocesseurs. Ces dispositifs ou ensembles émetteurs-récepteurs sont fréquemment désignés par leur dénomination anglo-saxonne « *transceiver* » parfois traduite par « *transcepteur* ».

Parmi les ensembles émetteurs-récepteurs de l'art antérieur, (voir WO 03/088283) on trouve différentes architectures de dispositifs électroniques, dont le fonctionnement dépend de l'application recherchée. Ainsi, la façon de transporter les informations numériques, c'est-à-dire de les encoder, puis de les décoder, dépend du débit d'informations à transmettre et de la distance sur laquelle il faut transporter ces informations. C'est la raison pour laquelle de nombreux standards de communication ont été créés pour répondre aux divers besoins spécifiques. Parmi ces standards, on en trouve de trois catégories.

La première catégorie comporte des standards non différentiels, dont les plus connus sont :

- le standard dit LVTTL (pour *Low Voltage Transistor Transistor Logic*) est transporté par une ligne simple avec une fréquence inférieure à 250 MHz ;
- le standard GTL (pour *Gunning Transceiver Logic*) utilise une ligne simple, dont le drain du transistor est ouvert et fonctionne à des fréquences inférieures à 200 MHz.

Ces deux standards sont généralement mis en oeuvre dans les circuits électroniques traditionnels pour des distances d'interconnexion relativement courtes (ex. : le standard GTL ou encore le bus de communication externe des Pentium Pro d'Intel) et des débits moyennement élevés. Comme dérivé du standard GTL, il existe le standard AGTL+ pour transporter des débits importants au moyen des bus des cartes mères.

La seconde catégorie est liée aux besoins de communication entre divers éléments d'une même unité électronique. Dans le cas où il s'agit de transférer des informations entre mémoires, il est nécessaire de disposer d'une bande passante importante, en particulier pour les mémoires à accès rapide, telles que les mémoires SRAM ou DRAM (pour *Static Random Access Memory* et *Dynamic Random Access Memory*). Pour une telle application, on utilise généralement le standard HSTL (pour *High Speed Transceiver Logic*) ou le standard SSTL (pour *Sub Series Terminated Logic*), lesquels permettent de transporter des informations numériques sur de très courtes distances avec des fréquences de l'ordre de 400 Mhz au moyen de lignes simples ou différentielles.

La troisième catégorie comporte des standards différentiels pour transporter des débits d'informations très élevés, typiquement à des fréquences supérieures à 800 Mhz, sur de longues distances, parfois de plusieurs centaines de mètres, comme dans le cas des réseaux ADSL (pour *Asynchronous Digital Subscriber Line*), on peut employer des liaisons série point-à-point fonctionnant selon les standards LVDS (*Low Voltage Differential Signalling*), ECL (pour *Emitter Coupled Logic*) ou CML (pour *Current Mode Logic*).

De manière connue, le standard LVDS s'appuie sur une technologie à base de CMOS, ce qui lui permet de présenter un bon rapport entre coût, consommation et performances, de l'ordre de 1 Gb/s pour une puissance de 1 mW.

Quant aux standards ECL et CML, ils permettent de transporter l'information à plus haut débit, typiquement de l'ordre de 2 Gb/s, mais pour une consommation nettement supérieure à celle du standard LVDS, typiquement de l'ordre de 200 mW, et pour un coût plus élevé, car il met en oeuvre une technologie spécifique.

La technologie mise en oeuvre par le standard LVDS utilise pour transmettre l'information sur de longues distances de faibles courants, de l'ordre de 3,5 mA et une connexion différentielle, qui permet de rejeter la plupart du bruit affectant les lignes de transmission puisque ce bruit apparaît très majoritairement en mode commun (pour lequel la réjection des circuits différentiels est très élevée). Cette réjection permet d'utiliser de faibles tensions, et donc de réduire la consommation électrique.

La présente invention se situe dans cette troisième catégorie des transceivers différentiels pour longues distance, avec en outre un haut débit d'informations à transmettre, sans avoir pour autant les inconvénients du standard LVDS.

Selon le standard LVDS, l'excursion de la tension de sortie de l'émetteur est relativement élevée, de l'ordre de 350 mV, qui correspond au seuil de fonctionnement des grilles des transistors d'entrée du récepteur. Comme le fonctionnement est différentiel, l'excursion en tension est au moins égale à deux fois ce seuil, soit environ 700 mV. Le courant requis pour transporter les informations numériques, quoique faible, demeure relativement élevé, de l'ordre de 3,5 mA. Par conséquent, la puissance dynamique nécessaire pour générer les signaux transportant les informations numériques est de l'ordre de 2,1 mW, et ne saurait fonctionner en dessous d'une excursion en tension différentielle de 700 mW.

En outre, compte tenu de l'impédance électrique de la ligne de transport, l'intégrité des signaux émis n'est pas garantie pour des distances de transport supérieures à 15 m. De plus, cette impédance empêche ces dispositifs électroniques d'adresser les informations numériques depuis un seul émetteur vers une pluralité de récepteurs, car les signaux sont dégradés lors de leur réception.

La présente invention a donc pour objet un dispositif électronique ne présentant pas les inconvénients des dispositifs de l'art antérieur, en particulier une consommation électrique excessive, une distance de transport des informations limitée et/ou un coût de mise en oeuvre onéreux et la limitation du nombre de récepteurs.

## OBJET DE L'INVENTION

La présente invention se rapporte donc à un dispositif permettant de transporter des informations numériques sur de longues distances de manière simple et économique à mettre en oeuvre, tout en ayant une consommation électrique faible, et en autorisant le « multi-adressage » des récepteurs, c'est-à-dire la possibilité pour un émetteur d'adresser simultanément plusieurs récepteurs, ceci grâce à une utilisation nouvelle de composants électroniques et magnétiques agissant en synergie, et à la mise en oeuvre d'éléments magnétiques pour réaliser une fonction de circuit logique. Plus précisément ces éléments magnétiques sont magnétorésistifs. Conformément à l'usage, ces éléments magnétorésistifs qui comportent au moins une couche ferromagnétique dure et une couche ferromagnétique douce séparées par une couche intercalaire non ferromagnétique (métallique ou isolante) sont appelés ci-après « empilements magnétorésistifs ». Dans de tels empilements, l'une ou l'autre des couches ferromagnétiques, ou les deux, peuvent être elles-mêmes composées de plusieurs couches ferromagnétiques et non ferromagnétiques conçues de telle manière que l'ensemble se comporte comme une seule couche ferromagnétique de performances améliorées, formant ce que l'on appelle une couche magnétique de synthèse. Dans ce qui suit, on écrira conformément à l'usage, « couche magnétique » en lieu et place de « couche ferromagnétique ».

L'objet de l'invention est un dispositif de transmission des informations numériques (« transceiver » en anglais) comportant des moyens électroniques, appelés émetteur, générant des impulsions de courant, au moins un ensemble de moyens de réception, appelés récepteur, convertissant les impulsions reçues en impulsions logiques compatibles avec le fonctionnement des circuits électroniques logiques standards.

Selon l'invention, le récepteur reçoit les impulsions de courant émises par l'émetteur dans un couple d'empilements magnétorésistifs, c'est-à-dire d'éléments magnétorésistifs comportant une couche ferromagnétique dure et une couche ferromagnétique douce séparées par une couche intercalaire, la couche dure de chaque empilement magnétorésistif étant piégée dans une orientation magnétique fixe, la couche douce de chaque empilement étant en l'absence de courant dans sa position de facile aimantation servant de référence, et présentant une orientation magnétique modulable par le champ magnétique généré par les impulsions de courant issues de l'émetteur, de manière à induire une modification de résistance proportionnelle à l'angle géométrique entre l'aimantation de la couche dure et celle de la couche douce, suffisante pour déclencher un signal électrique en tension ou en courant, les modifications de résistance des deux empilements traversés par une même impulsion coopérant pour former un signal différentiel.

De manière préférentielle, les deux empilements sont identiques mais excités en sens inverse par le courant issu de l'émetteur et ayant parcouru la ligne de transmission reliant l'émetteur au récepteur considéré, créant ainsi le fonctionnement différentiel.

Habituellement, l'axe de facile aimantation de la couche douce de chaque empilement magnétorésistif est aligné avec l'aimantation de la couche dure : ainsi, le basculement de l'aimantation de la couche dure entre les deux positions stables (à 0 et 180 degrés par rapport à l'axe de facile aimantation) permet d'atteindre des états magnétiques parallèle et antiparallèle à l'aimantation de la couche dure, maximalisant ainsi les variations de résistance.

Dans l'application visée par la présente invention, un fonctionnement bistable ne s'impose pas, le but étant en effet d'accroître la vitesse de traitement. Selon l'invention, l'aimantation ne va donc pas basculer entre deux états stables, mais fluctuer (sous influence du champ magnétique généré par les impulsions de courant) autour d'une position stable, avec un angle de préférence strictement compris entre - 90 et 90 degrés par rapport à cette position stable. Lorsque le champ magnétique est supprimé, l'aimantation revient dans sa position d'équilibre. Dans cette approche, les empilements magnétiques peuvent différer légèrement par rapport à ceux utilisés dans une application classique de type mémoire.

Selon l'invention, l'aimantation de la couche dure est perpendiculaire à l'axe de facile aimantation de manière à approcher des états parallèle et antiparallèle lorsque l'aimantation fluctue entre -90 et 90 degrés, sans toutefois atteindre ces valeurs.

De manière préférentielle, les empilements magnétorésistifs sont réalisés de manière à ce que la stabilité des axes de facile aimantation soit faible, de manière à ce qu'un faible champ magnétique suffise à les écarter de cette position, le but n'étant pas ici le maintien stable de l'information comme dans le cas d'une mémoire.

Ceci est généralement réalisé selon un premier mode de réalisation de l'invention dans lequel des empilements magnétorésistifs ont la forme de plots de section quasi-cylindrique, et non elliptique comme dans les mémoires qui s'efforcent au contraire d'avoir deux états très stables.

Selon un second mode de réalisation de l'invention, les deux empilements magnétorésistifs sont suffisamment proches l'un de l'autre pour qu'il existe entre leurs couches douces un couplage magnétostatique. Dans ce cas le changement d'orientation de la couche douce d'un empilement magnétorésistif contribue au changement de l'orientation de l'autre empilement magnétorésistif. Par cette interaction magnétostatique, le basculement de l'une des couches douces contribue au basculement de l'autre : ce phénomène de réaction positive de chaque empilement sur l'autre accroît la vitesse de commutation et autorise des bandes passantes très élevées.

Selon ce second mode de réalisation, il est préférable que leur forme diffère de plots de section circulaire, et ait au contraire la forme de deux lettres C ou deux lettres U se faisant face, de manière à minimiser les entrefers séparant chaque empilement de l'autre.

De manière préférentielle, la modulation de l'orientation magnétique de la couche douce de chaque empilement est suffisamment faible pour que cette orientation de l'aimantation varie autour d'une position d'équilibre sans qu'il y ait basculement proprement dit, c'est à dire sans que lors de la suppression du courant l'aimantation ne relaxe dans sa position d'équilibre opposé à la position d'équilibre initial. Cette configuration minimise l'énergie nécessaire à la modification de leur orientation magnétique et augmente la vitesse de commutation.

Toutefois, lorsque cette dernière condition préférentielle n'est pas remplie et qu'il se produit un basculement de l'aimantation en l'absence de courant, le fonctionnement du « transceiver » ne s'en trouve pas affecté. En effet, l'axe de facile aimantation de la couche douce étant perpendiculaire à celui de la couche dure, s'il vient à basculer de 180° la configuration est symétrique par rapport à la configuration avant basculement et le fonctionnement également.

Selon l'invention, l'émetteur et le ou les récepteurs sont montés en série.

Par l'expression « reçoit les impulsions de courant dans un couple d'empilements magnétorésistifs », on entend au sens de l'invention que ces impulsions circulent dans un conducteur disposé au voisinage de l'un et l'autre des empilements magnétorésistifs, selon une orientation, un sens et à une distance choisis pour que ces impulsions de courant modifient l'orientation de l'aimantation de la couche douce de chacun de ces empilements magnétorésistifs. Il en résulte que ce courant n'occasionne pas une chute de tension décelable puisque l'impédance d'entrée du dispositif est un simple tronçon de conducteur électrique passant au voisinage de deux empilements magnétorésistifs.

À titre d'exemple, pour produire un champ de 7 Oe nécessaire au retournement d'une jonction de section cylindrique, il suffit d'un courant de 3 mA dans une ligne de 1 m de long (c'est-à-dire quasi-infinie devant les dimensions du transceiver), dont la section a 500 nm de large sur 100 nm de haut, située à 200 nm des jonctions à écrire.

La taille d'une jonction étant de l'ordre de 300 nm, on estime que la longueur de ligne d'écriture qui participe au basculement de cette jonction est de 1 $\mu$m. La ligne étant en cuivre, la résistance d'un tronçon de 1 $\mu$m est de 0,3 ohms environ.

Pour le courant d'écriture de 3 mA, la puissance consommée dans cette jonction est de 2, 7 $\mu$w alors que le standard LVDS requiert sous une tension d'au moins 0,6 V une puissance d'environ 2 mW, c'est-à-dire 740 fois plus. En outre le standard LVDS exigeait un produit RI constant, alors que l'invention se contente d'un courant au moins égal à 3 mA, et qui doit seulement ne pas atteindre une valeur à ce point élevée qu'elle ferait basculer de manière non voulue une autre jonction.

Il n'y a pas de dissipation de puissance décelable à l'intérieur du récepteur, et le nombre de récepteurs placés en série sur le trajet d'une même ligne électrique est extrêmement élevé, limité seulement par la résistance globale de cette ligne et la capacité de l'émetteur à y générer le courant requis.

On peut également noter qu'il n'existe pratiquement pas de seuil de fonctionnement en tension pour un transceiver selon l'invention. En outre, cette impédance d'entrée quasi-nulle améliore significativement l'immunité aux bruits. En effet, les bruits électromagnétiques sont modélisables par une source de tension en série avec une impédance

interne $Z_0$, qui est généralement moyenne ou élevée, voire très élevée. Lorsque les bruits induisent une tension dans un circuit d'impédance Zi, celle-ci se trouve divisée par le rapport d'impédances Zi / ($Z_0$ + Zi), de sorte qu'il est connu d'abaisser l'impédance d'entrée des circuits pour limiter l'incidence des bruits électromagnétiques. Avec une impédance d'entrée Zi quasi-nulle, l'invention se situe dans des conditions optimales, encore jamais réalisées, pour diminuer la vulnérabilité aux bruits.

Il va de soi pour l'homme du métier que la mise en oeuvre d'empilements magnétorésistifs dans l'invention implique l'existence, dans le récepteur, d'un circuit intégré électronique d'alimentation apte à polariser la partie magnétorésistive du récepteur et d'un circuit intégré électronique de lecture apte à mesurer la résistance de l'empilement et à la traduire sous forme de niveaux logiques.

En d'autres termes, le dispositif électronique objet de l'invention comporte un émetteur et un récepteur magnétiquement couplés, l'émetteur générant un courant d'écriture de manière à modifier l'orientation magnétique des couches magnétiques douces de chacun des empilements d'un couple d'empilements magnétorésistifs.

L'émetteur est constitué des moyens électroniques pour générer dans la boucle d'écriture un courant engendrant localement un champ magnétique de façon à en moduler l'orientation magnétique des couches douces. Il s'agit généralement d'un circuit intégré électronique. Dans le récepteur, ce courant parcourt un conducteur placé selon une orientation et à une distance permettant cette modulation.

Comme le même courant circule au voisinage des deux empilements magnétorésistifs, selon une orientation et à une distance lui permettant de moduler l'orientation magnétique de la couche magnétique douce, et que les signaux de sortie sont associés de manière à coopérer, les couples d'empilements magnétorésistifs fournissent un signal différentiel qui amplifie davantage les le signal utile que les artefacts tendant à affecter les magnétorésistances en mode commun.

De manière préférentielle, les empilements magnétorésistifs sont polarisés en tension au moyen d'électrodes placées de part et d'autre de l'empilement par rapport au plan des couches, la grandeur électrique mesurée étant le courant traversant cet empilement magnétorésistif perpendiculairement au plan des couches. Mais selon une variante les empilements magnétorésistifs sont polarisés en courant, et la grandeur électrique mesurée est la différence de potentiel entre les extrémités de l'empilement magnétorésistif.

Selon une forme de réalisation pratique de l'invention, les circuits intégrés de l'émetteur et du récepteur peuvent être réalisés par la technologie CMOS. Le dispositif électronique ainsi constitué combine alors la technologie CMOS et les dispositifs magnétiques, en particulier magnétorésistifs, tels qu'ile existent dans les mémoires magnétiques MRAM (pour *Magnetic Random Acess Memory*). Si l'association de ces deux technologies existe déjà dans l'art antérieur lorsqu'il est nécessaire de bénéficier des fonctions des deux technologies (comme par exemple dans des mémoires magnétiques dont les circuits de mise en oeuvre et le multiplexage /démultiplexage sont électroniques), cette association ne présente aucune synergie susceptible de conduire à des performances supérieures à la somme des performances de chaque technologie prise séparément. Il n'existe pas non plus de circuits logiques (au sens de circuit logique électronique) mettant en oeuvre des composants magnétiques.

Une autre caractéristique importante de l'invention réside dans le choix du courant des impulsions électriques déclenchant le récepteur. Les dispositifs magnéto résistifs mis en oeuvre dans le récepteur comportent une couche dure, dont l'aimantation est fixée selon une direction de référence, et une couche douce conçue pour que son aimantation soit le plus possible parallèle ou antiparallèle avec la direction de l'aimantation de la couche dure en fonctionnement, afin de maximiser les variations de résistance. Par « le plus possible », on entend qu'il s'agit d'un objectif du concepteur, mais que pour certaines formes des couches magnétiques, notamment celles qui ont la forme de la lettre C ou U, il n'est pas possible de garder, en tout point de la couche magnétique, cet antiparallélisme. Dans ce dernier cas, la forme des couches magnétiques est néanmoins conçue de manière à ce que le comportement global de ce circuit soit le comportement des portions où les orientations magnétiques de la couche dure et de la couche douce sont parallèles ou antiparallèles.

Lors de la transmission d'un signal logique « 0 » ou « 1 », l'orientation magnétique de la couche douce se décale selon le cas d'un angle préférentiellement compris entre -90 et 90 degrés. Ceci par opposition avec les dispositifs de mémoires magnétiques où le décalage recherché et de 180 degrés (retournement de la direction d'aimantation). Ce décalage de l'orientation magnétique de la couche douce d'un peu moins de ± 90 degrés requiert un champ magnétique inférieur au champ magnétique requis pour un retournement tels qu'utilisé dans les mémoires.

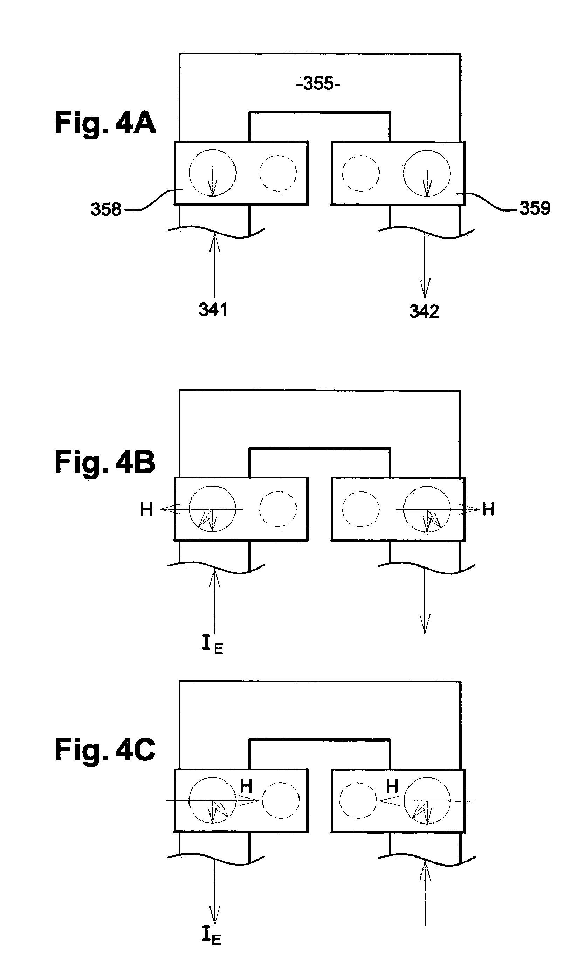

La couche douce de chaque empilement magnétorésistif s'oriente en l'absence de courant dans la ligne reliant l'émetteur au récepteur, selon son axe de facile aimantation (cf. Fig. 4a) perpendiculaire à l'aimantation de la couche dure. La modulation de son orientation magnétique par rapport à son orientation au repos afin d'obtenir l'un ou l'autre des deux états instables engendrés de manière reproductible et fiable par l'impulsion de courant dans un sens ou dans l'autre, selon que la valeur transmise est 0 ou 1, est caractéristique de l'invention (cf. Fig. 4b et 4c).

Le choix d'une impulsion de courant modulant cette orientation de ± 90 degrés par rapport à sa position d'équilibre selon le signal logique « 0 » ou « 1 »reçu, constitue une réalisation préférentielle en ce qu'elle maximise le TMR (pour « *Tunnel MagnetoResistance* », qui représente la variation relative de résistance ohmique entre les états d'orientation extrêmes) lorsque l'angle entre l'orientation magnétique de la couche dure et celle de la couche douce est de 0° ou 180°.

Mais une modulation d'un angle inférieur à 90° reste conforme à l'invention dès lors qu'elle permet une variation décelable, reproductible et fiable de la résistance électrique transversale de chaque empilement magnétique. Il permet à l'homme du métier d'adapter le principe de l'invention à diverses configurations particulières, par exemple pour diminuer la consommation ou augmenter la vitesse de commutation de l'ensemble du transceiver.

Une troisième caractéristique importante de l'invention concerne la stabilité des états magnétiques. Dans les dispositifs mémoires magnétorésistifs, une stabilité élevée des états magnétiques est recherchée, qui conduit généralement aux choix d'une forme ovale, assez éloignée d'un cercle, pour la forme des couches magnétiques constituant l'empilement magnétorésistif. Dans l'invention, au contraire, on recherche une faible stabilité des deux états magnétiques, qui n'ont jamais besoin d'être maintenus longtemps. Cette faible stabilité contribue aussi à diminuer le temps de réponse, donc augmenter la cadence maximale de transmission. Ainsi les jonctions magnétiques ont préférentiellement une forme ronde, qui minimise cette stabilité, ou une forme proche d'un cercle. À titre d'exemple, le retournement de l'aimantation dans une jonction ronde est typiquement de 5 à 7 oe, alors qu'il serait de 50 à 70 oe dans le cas d'une jonction semblable mais de forme ovale, telle qu'utilisée classiquement dans le cadre des mémoires. Selon une variante alternative, cette faible stabilité peut être obtenue par un choix judicieux des matériaux magnétiques constituant chaque magnétorésistance, ou par une combinaison entre le choix des matériaux et la forme de l'empilement magnétorésistif.

Selon une réalisation préférentielle de l'invention, les couples d'empilements magnétorésistifs ont leurs couches magnétiques douces placées de telle manière qu'il existe entre elles un couplage magnétostatique suffisamment fort pour que le basculement d'une de ces couches douces induise le basculement en sens inverse de l'autre couche douce, leurs aimantations restant toujours antiparallèles.

Une telle structure permet de minimiser le courant circulant dans le via reliant les deux branches de la boucle de la ligne d'écriture, puisqu'un tel couplage magnétostatique facilite la modulation de l'orientation magnétique des couches douces. Un tel couplage magnétostatique contribue en outre au maintien des deux jonctions magnétiques dans des orientations magnétiques opposées, renforçant le fonctionnement différentiel.

Selon une variante préférentielle de la précédente, les deux éléments de chaque couple d'empilements magnétorésistifs sont placés du même côté d'un même substrat, et le couplage magnétique entre leurs couches douces est obtenu en donnant à chacun de ces empilements une géométrie en forme de C, et en plaçant ces deux éléments face à face, les ouvertures des deux C étant tournées l'une vers l'autre.

En d'autres termes, les deux empilements magnétorésistifs d'un couple peuvent être constitués par des éléments en forme de C positionnés dans un même plan de manière à définir entre eux deux entrefers et à former essentiellement une couronne, sur l'axe de symétrie de laquelle se trouve un via reliant les branches de la boucle d'écriture. Une telle structure permet d'augmenter le couplage magnétostatique entre les deux empilements magnétorésistifs et de créer une réaction positive entre le changement d'orientation d'une des couches douces et le changement d'orientation de l'autre couche douce, ce couplage tendant à les maintenir antiparallèles. Avantageusement, la lettre C est déformée de manière à assurer la prépondérance fonctionnelle des zones où la couche douce à une orientation magnétique parallèle ou antiparallèle à celle de la couche dure.

Selon une seconde variante préférentielle, les deux éléments de chaque couple d'empilements magnétorésistifs sont placés du même côté d'un même substrat, et le couplage magnétique entre leurs couches douces est obtenu en donnant à chacun de ces empilements une géométrie en forme de U, et en plaçant ces deux éléments face à face, les ouvertures des deux U étant tournées l'une vers l'autre.

Avantageusement, la lettre U est déformée de manière à assurer la prépondérance fonctionnelle des zones où la couche douce à une orientation magnétique antiparallèle à celle de la couche dure. Ainsi cette seconde variante peut encore être améliorée en constituant le U non par deux branches parallèles réunies par un demi-cercle, mais par deux branches parallèles réunies par une troisième branche perpendiculaire, dont la longueur est inférieure aux branches parallèles et avantageusement la plus courte possible. A titre d'exemple, on peut réunir deux branches parallèle de longueur L par une branche perpendiculaire de longueur L'≤ L, L' étant la longueur mesurée entre les deux branches.

Le couplage magnétorésistifs rend possible et avantageux d'effectuer le basculement des éléments magnétorésistifs avec un courant plus faible que celui qui est utilisé dans des éléments magnétorésistifs utilisés pour la mémorisation. En outre, une moindre saturation favorise le basculement rapide, et donc une fréquence de fonctionnement élevée pour le transceiver.

De telles jonctions présentent en effet des performances intéressantes, en particulier en termes de temps de réponse à un champ magnétique.

Selon une forme de réalisation alternative de l'invention, les jonctions magnétiques à effet tunnel peuvent être magnétiquement indépendantes l'une de l'autre.

Selon un mode de réalisation pratique de cette forme de réalisation de l'invention, les éléments magnétorésistifs peuvent être constitués chacun par un plot cylindrique.

Une telle géométrie permet d'orienter les couches douches relativement facilement, c'est-à-dire avec une consommation faible, et d'avoir une réactivité de l'aimantation relativement rapide (en mode capteur avec une couche dure orientée à 90 degrés).].

Selon une caractéristique particulière de l'invention, les éléments magnétorésistifs peuvent être constitués chacun d'une jonction magnétique à effet tunnel.

En pratique, les jonctions magnétiques peuvent être réalisées en oxyde de magnésium (MgO) et les électrodes à partir d'alliages de fer, de cobalt et/ou de bore.

En pratique, le circuit intégré de lecture peut être apte à amplifier le différentiel de courant de façon à générer une tension représentative de la résistance électrique des éléments résistifs.

Ainsi, le circuit de lecture délivre un signal modulé en tension, dont l'exploitation peut être aisément réalisée par des périphériques appropriés, tels que ceux réalisés en technologie CMOS.

Selon un mode de réalisation de l'invention, le dispositif électronique objet de l'invention peut comprendre plusieurs récepteurs magnétiquement couplés en série à l'émetteur par l'intermédiaire des branches d'écriture.

En pratique, tous ces récepteurs peuvent être affectés de façon identique par le courant d'écriture.

Cette forme de réalisation de l'invention permet d'adresser une même information numérique à plusieurs récepteurs au moyen d'une seule ligne d'écriture.

En pratique encore, les couches douces peuvent présenter chacune une anisotropie magnétique faible, de manière à permettre une modulation de leurs orientations magnétiques rapide et peu consommatrice d'énergie.

Ainsi, la chute de tension le long de la ligne d'écriture n'a pas d'impact sur le récepteur, de sorte qu'on peut se passer de répéteurs ou d'amplificateurs tout en conservant l'intégrité du signal. Le coût énergétique est identique pour un ou plusieurs récepteurs.

Selon une forme de réalisation avantageuse de l'invention, les jonctions magnétiques peuvent présenter une faible surface de résistance et une magnétorésistance élevée, de préférence supérieure à 200%. Ce faisant, on augmente la vitesse de transmission binaire, la vitesse de conversion magnétique étant supérieure à la vitesse électrique (CMOS).

## BREVE DESCRIPTION DES FIGURES

La manière dont l'invention peut être réalisée et les avantages qui en découlent ressortiront mieux de l'exemple de réalisation qui suit. Cet exemple est donné à titre indicatif et non limitatif, à l'appui des figures annexées parmi lesquelles :

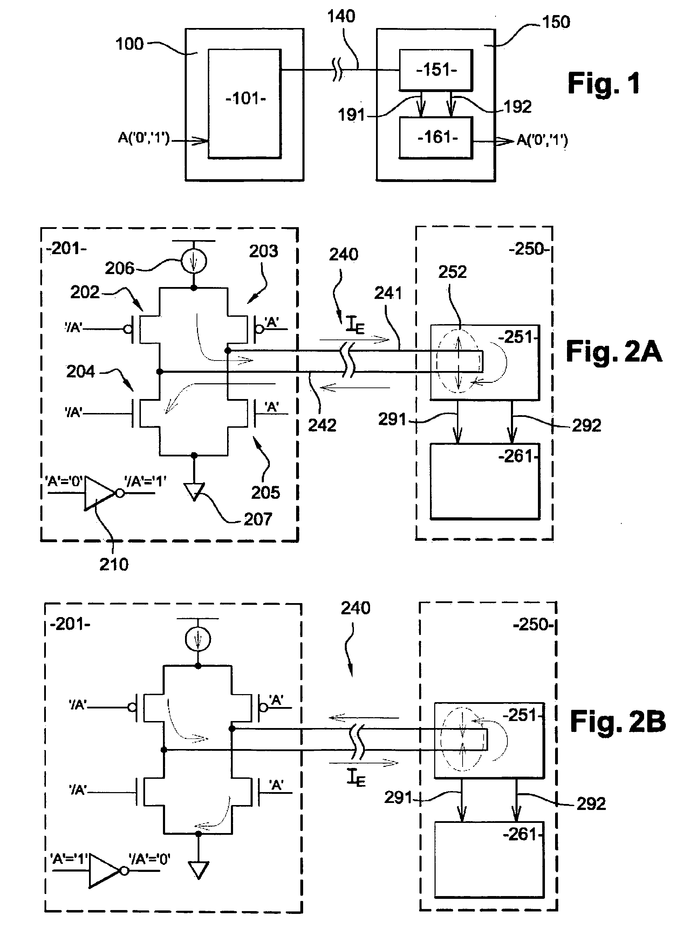

■ la figure 1 est une représentation schématique des blocs fonctionnels émetteur et récepteur d'un dispositif électronique conforme à l'invention ;

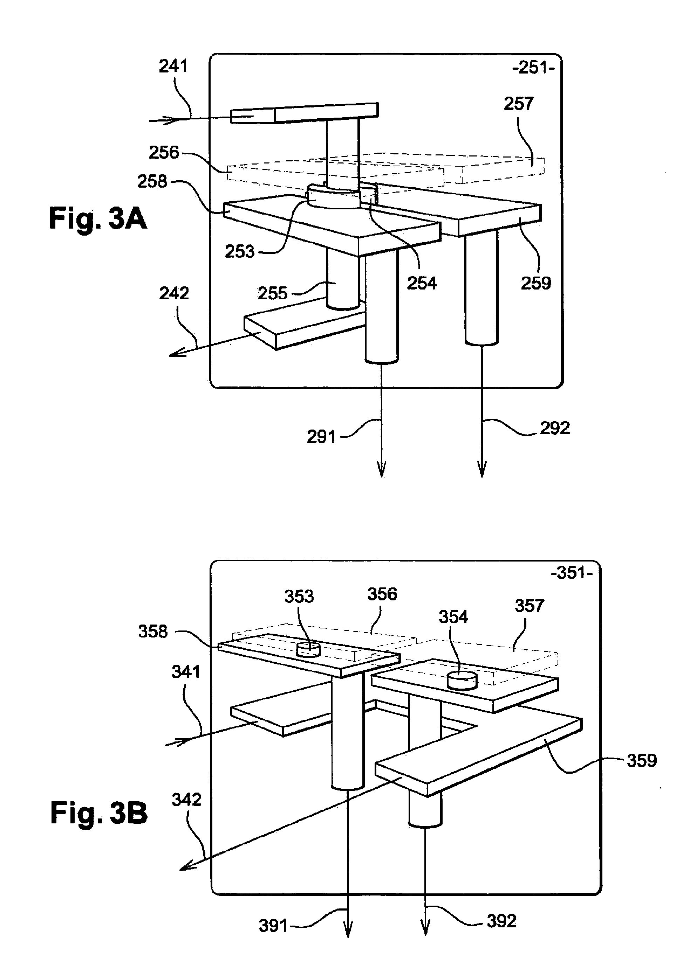

les figures 2a et 2b sont des représentions schématiques du dispositif électronique illustré par la figure 1 ; sur ces figures apparaissent les détails du circuit intégré constituant l'émetteur et du dispositif magnétorésistif constituant le premier étage du récepteur ; la figure 2a illustre le transport de l'information numériques «0», tandis que la figure 2b illustre le transport de l'information numérique «1» ; les figures 3a et 3b sont des représentations schématiques en perspective de deux architectures différentes permettant de réaliser le dispositif magnétorésistif du récepteur pour un dispositif conforme à la présente invention;

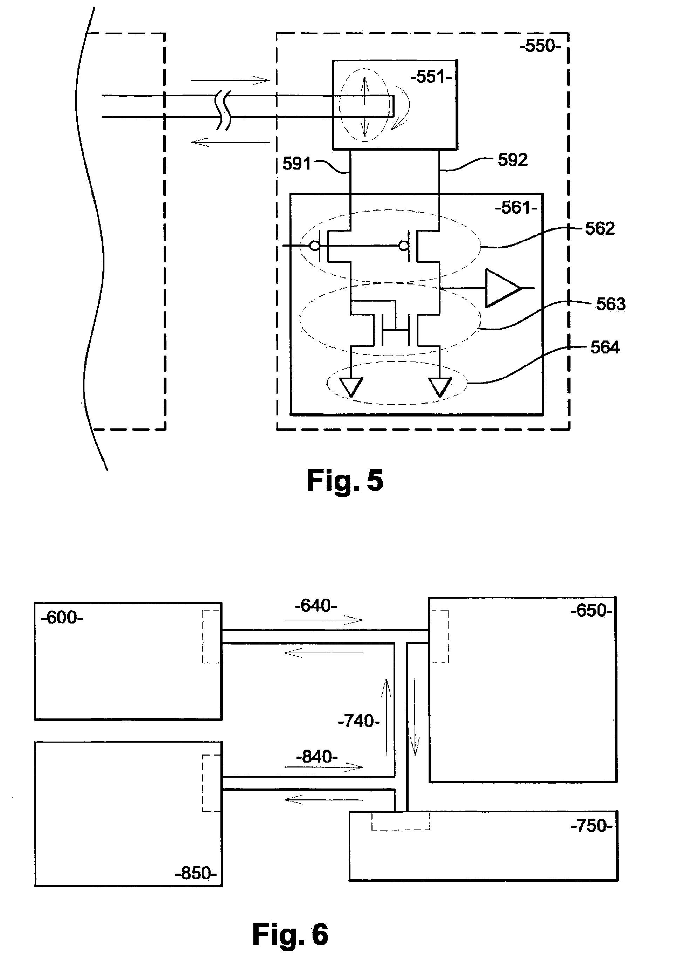

les figures 4a à 4c illustrent le fonctionnement du dispositif magnétorésistif illustré par la figure 3b, en particulier les orientations magnétiques des couches douces des éléments magnétorésistifs d'un tel dispositif ; les figures 4a, 4b et 4c montrent respectivement le dispositif magnétorésistif au repos, lors de la transmission d'un «0» et lors de la transmission d'un «1»; intégré de lecture la figure 5 est une représentation schématique d'un circuit intégré de lecture constituant le deuxième étage du récepteur d' un dispositif électronique conforme à l'invention;

la figure 6 est une représentation schématique par bloc fonctionnel montrant le multi-adressage d'informations numériques depuis un émetteur vers plusieurs récepteurs.

## MODES DE REALISATION DE L'INVENTION

La figure 1 illustre les blocs fonctionnels composant un dispositif électronique conforme à l'invention. Un émetteur **100** comprenant un circuit intégré **101** est destiné à écrire dans le premier étage **151** d'un récepteur **150** par l'intermédiaire d'une boucle d'écriture **140**. Par écriture on désigne en fait l'émission de signaux électriques par Modulation de courant depuis le circuit intégré d'écriture **101** vers le premier étage **151** du récepteur **150**. D'autre part, le récepteur **150** comporte un circuit intégré de lecture **161** électriquement relié au premier étage **151** par l'intermédiaire de connexions **191** et **192**. étage par

La longueur de la boucle ou ligne d'écriture **140** représente la distance sur laquelle les informations numérique «0» et «1» sont transportées. Bien évidemment, les informations numériques parviennent au circuit intégré d'écriture **101** depuis une source située en amont et schématisée sur la figure 1. De même, le circuit intégré de lecture **161** du récepteur **150** transmet les informations numériques provenant de l'étage magnétorésistif **151** qu'il a décodées à un ou plusieurs autres composants aptes à exploiter ces informations numériques.

Les figures 2a et 2b illustrent plus en détail le fonctionnement du dispositif électronique schématisé sur la figure 1. Sur ces figures, les références numériques désignant des pièces semblables à celles de la figure 1 sont augmentées de 100.

Conformément à l'invention, le circuit intégré d'écriture **201** est entièrement réalisé en technologie CMOS. Ce circuit d'écriture **201** comporte quatre transistors **202-205** montés deux à deux en parallèle. En l'espèce, les transistors de la paire **202-203** sont du type PMOS, tandis que les transistors de la paire **204-205** sont du type NMOS respectivement pour *Positive Metal Oxyde semiconductor* et *Negative Metal Oxyde semiconductor*).

D'une part, les transistors PMOS **202-203** (symbolisés par un cercle apporté sur leurs grilles) ont leurs sources communes (connectées au générateur de courant) et, d'autre part, les transistors NMOS **204-205** ont leurs sources communes connectées à la masse **207.**

La source commune est alimentée par un générateur de courant **206** délivrant un courant pouvant être inférieur à 3 mA, ce qui, en pratique, est inférieur au courant nécessaire au fonctionnement d'un dispositif mettant en oeuvre le standard LVDS (3,5 mA).

Pour le reste, le circuit intégré d'écriture **201** fonctionne de manière semblable aux circuits intégrés des émetteurs mis en oeuvre avec le standard LVDS. De plus, les transistors **202** et **204** sont reliés à la sortie d'un inverseur logique **210,** tandis que les transistors **203** et **205** sont reliés à l'entrée de l'inverseur logique **210.**

Par conséquent, si l'information logique à transmettre, appliquée à l'entrée de l'inverseur logique est « 'A'=0 », les transistors **203** et **204** sont en mode 'on', tandis que les transistors **202** et **205** sont en mode 'off' et réciproquement si « 'A'=1 », les PMOS étant actifs si leur grille est à «0», les NMOS sont actifs si leur grille est à «1» ; ceci permet d'assurer la bidirectionnalité du courant dans la boucle **240.**

Par conséquent, si « A'=0 », le courant provenant de la source connectée au générateur de courant **206** circule dans le transistor **203** jusqu'à une branche **241** de la ligne d'écriture **240** pour atteindre l'étage magnétorésistif **251** du récepteur **250.**

Comme les branches **241** et **242** ne forment en fait qu'une boucle **240**, ce courant revient par la branche **242** dans l'émetteur **201**, où il s'écoule à travers le transistor **204** vers la source commune/la masse **207.** Ainsi, l'information numérique «0» a été transportée depuis l'émetteur **201** vers l'étage magnétorésistif **251** par l'intermédiaire de la boucle d'écriture **240.** Inversement, la figure 2b illustre le transport de l'information numérique «1» dans la ligne d'écriture **240.** Pour cela, l'entrée de l'inverseur logique **210** est mise sous tension, plaçant sa sortie à un potentiel nul (0V).

Comme le courant d'écriture circule dans les branches **241** et **242** selon des directions opposées (aller ou retour), il est parfois qualifié de courant *bidirectionnel.* Conformément à l'invention, ce courant arrive dans l'étage **251** du récepteur **250** et il circule il proximité du dispositif magnétorésistif caractéristique de la présente invention. Le fonctionnement de ce dispositif magnétorésistif est détaillé ci-après, mais il est déjà schématisé sur les figures 2a et 2b.

Ainsi, une ellipse **252** symbolise les orientations magnétiques d'une couche ferromagnétique douce appartenant à l'un des éléments magnétorésistifs du dispositif constituant l'étage magnétique **251** du récepteur **250.** Les flèches contenues dans l'ellipse **252** symbolisent les champs magnétiques coercitifs générés localement par le courant d'écriture. Conformément à l'invention, les couches ferromagnétiques douces sont formées par des jonctions magnétiques à effet tunnel. Comme le montrent les figures 2a et 2b, ces jonctions magnétiques sont, conformément à l'invention, constamment en opposition de phase l'une par rapport à l'autre. Dans ce cas précis, les jonctions magnétiques sont donc magnétiquement couplées.

La figure 3a illustre l'architecture du dispositif magnétorésistif **251** avec deux éléments magnétorésistifs **253, 254** en forme de **C** magnétiquement couplés. Le courant d'écriture $I_E$ arrive ici par la branche **241** et repart par la branche **242.** Entre ces deux branches, le courant d'écriture $I_E$ transite par une via **255** constituée d'un conducteur électrique s'étendant à égale distance des éléments magnétorésistifs **253** et **254.** Ces éléments **253** et **254** en forme de C, ou de demi-couronnes, sont tournés l'un vers l'autre, tandis que la via **255** est positionnée de manière coaxiale à l'axe de symétrie de l'ensemble formé par les deux éléments magnétorésistifs **253** et **254.**

Ainsi, le courant d'écriture transportant une information numérique «0» ou «1» génère un champ magnétique au niveau des éléments magnétorésistifs **253** et **254.** Chacun de ces éléments magnétorésistifs **253** et **254** est composé d'une couche ferromagnétique dure (non représentée) et d'une couche ferromagnétique douce (non représentée). Ces deux couches sont séparées par une couche intercalaire (non représentée). Toutefois, les éléments magnétorésistifs **253** et **254** pourraient également être composés d'un empilement de plusieurs couches en matériaux magnétiques ou amagnétiques différents.

Par conséquent, il n'y a pas de contact électrique direct entre le circuit intégré d'écriture et l'étage magnétique **251** du récepteur. C'est pourquoi le courant d'écriture $I_E$ n'est pas influencé ni altéré lorsqu'il circule dans la boucle **240** formée par les branches **241** et **242.** Comme cela est exposé par la suite en relation avec la figure 6, cette propriété permet d'adresser la même information numérique depuis un seul émetteur vers plusieurs récepteurs. Au contraire, dans le cas des dispositifs électroniques fonctionnant selon les standards LVDS, on génère une tension différentielle entre les deux branches de la ligne d'écriture, laquelle est lue au niveau du récepteur. Le courant support de l'information est donc altéré dans le récepteur au moment de la mesure de la différence de tension entre les branches, ce qui empêche la transmission de la même information à d'autres récepteurs.

De manière connue, par exemple dans le domaine des mémoires MRAM (pour *Magnetic Random Access Memory*), la couche dure de chacun des éléments magnétorésistifs est piégée dans un état magnétique fixe qui sert de référence, tandis que chaque couche douce présente une orientation magnétique variable. Précisément, l'orientation magnétique des deux couches douces est modifiée par le passage du courant d'écriture dans le via **255**. La résistance de l'empilement ainsi réalisé dépend de la différence angulaire des moments magnétiques des deux couches. L'angle, référencé par rapport à l'axe facile est nul pour la couche dure, la résistance ne dépend donc que de l'angle entre le moment magnétique de la couche douce et l'axe facile de celle-ci.

Conformément à l'invention, le dispositif magnétorésistif **251** est relié électriquement au circuit intégré de lecture **261** par l'intermédiaire de conducteurs **291** et **292**. Selon un principe connu, le circuit intégré de lecture mesure la valeur de la résistance électrique de chacun des éléments magnétorésistifs **253** et **254** en injectant un courant de lecture par l'intermédiaire des conducteurs **291** et **292.**

Le dispositif magnétorésistif **251** permet donc de détecter les variations du champ magnétique local qu'engendre le courant d'écriture lors de son passage dans la via **255** qui forme une connexion différentielle. Le dispositif magnétorésistif **251** convertit donc l'information numérique transportée par le courant d'écriture en une variation de grandeur électrique que le deuxième étage **261** peut interpréter. Le fonctionnement du deuxième étage est détaillé ci-après en relation avec la figure 5.

Comme exposé précédemment, les deux jonctions magnétiques à effet tunnel que forment les éléments magnétorésistif **253** et **254** sont magnétostatiquement couplées entre elles, de manière à ce que leurs orientations se trouvent constamment en opposition de phase. Une telle structure permet donc de réduire au minimum le courant d'écriture qu'il est nécessaire de faire circuler dans la via **255** pour moduler les orientations magnétiques des couches douces des éléments **253** et **254**. En effet, le couplage magnétostatique entre les éléments **253** et **254** « double » la variation de l'orientation magnétiques de l'une ou l'autre des couches douces.

Ainsi, même une faible variation d'orientation magnétique peut être mesurée à l'aide du courant de lecture. En effet, compte tenu de la variation de la résistance de chacun des éléments **253** et **254,** lorsque l'on polarise les jonctions magnétiques par l'intermédiaire d'électrodes **256** et **257** respectivement en contact avec les éléments **253** et **254,** le circuit de lecture **261** collecte des courants différents sur l'un et l'autre des conducteurs **291** et **292.** Par la suite, le circuit intégré de lecture **261,** réalisé en technologie CMOS, peut amplifier cette différence de courant de façon à retranscrire l'information numérique qu'elle représente («0» ou «1») sous la forme d'une tension.

La figure 3b illustre une architecturé alternative à celle du dispositif magnétorésistif **251** Comme le fonctionnement du dispositif magnétorésistif **351** représenté sur la figure 3b est analogue au fonctionnement au dispositif magnétorésistif **251** de la figure 3a, il ne sera pas exposé en détail sauf pour en souligner les singularités.

En l'occurrence, les deux éléments magnétorésistifs **353** et **354** sont ici magnétiquement indépendants l'un de l'autre. Ces éléments magnétorésistifs **353** et **354** peuvent être formés par des jonctions magnétiques à effet tunnel conventionnelles, par exemple présentant un empilement de matériaux identiques à ceux utilisés dans les mémoires MRAM (*pour Magnetic Random Access Memory*).

En particulier, les couches ferromagnétiques douces de cette jonction magnétique peuvent présenter une forme circulaire ou quasi circulaire de façon à minimiser l'énergie, donc le courant d'écriture, nécessaire à la Modulation de leur orientation magnétique.

En effet, contrairement aux mémoires MRAM, le but n'est pas le stockage stable et non volatil d'une information, mais son transfert rapide au moyen d'une consommation faible. C'est pourquoi des couches douces de forme circulaire induisent des seuils de commutation faibles et une dynamique de la couche douce, c'est-à-dire une possibilité de modulation de son orientation, importante. Ces deux derniers Paramètres Permettent donc d'obtenir des cycles d'aimantation des couches libres présentant des temps de réponse très faibles, ce qui accroît d'autant la vitesse de lecture des informations numériques parvenues au récepteur.

Les figures 4a à 4c illustrent différentes phases de fonctionnement du dispositif magnétorésistif **351** illustré par la figure 3b. La figure 4a illustre l'état de repos du dispositif magnétorésistif **351,** la figure 4b illustre la transmission d'un « 0 », tandis que la figure 4c illustre la transmission d'un « 1 ».

Ces figures 4a à 4c montrent la fin de la boucle d'écriture ainsi que les deux branches **341** et **342** qui la constituent. Deux électrodes **358** et **359** servent à polariser les éléments magnétorésistifs **353** et **354.** Les électrodes **358** et **359** sont représentées chacune avec un cercle en trait plein symbolisant l'orientation magnétique de la couche douce de l'élément magnétorésistif correspondant ainsi qu'avec un cercle en traits pointillés matérialisant chacun des conducteurs **391** et **392** reliant l'étage « magnétique » **351** à l'étage électronique de lecture du récepteur.

Dans un récepteur conforme à la présente invention, la détection des informations numériques reçues est opérée par le circuit CMOS de lecture sous un champ magnétique. Le champ magnétique local **H** généré par le courant de lecture circulant dans les branches **341** et **342** doit donc stabiliser les orientations magnétiques des éléments magnétorésistifs **353** et **354** durant la phase de lecture par le circuit CMOS situé en aval du dispositif magnétorésistif **351.**

Or, la durée de cette phase de lecture par le circuit CMOS est fonction des valeurs absolues et relatives du courant généré par une polarisation entre les électrodes **356** et **358** d'une part et les électrodes **357** et **359** d'autre part. Pour minimiser la durée de cette phase de lecture, il faut donc maximiser la valeur du courant de polarisation. Si l'on tient compte des problèmes de fluctuation des process magnétiques et électroniques dans le circuit CMOS, il est alors nécessaire de choisir une faible résistance nominale (faible constante de temps) pour chaque jonction magnétique et une forte magnétorésistance tunnel.

Si l'on considère maintenant la partie gauche de la figure 4a, en particulier au niveau de l'électrode **358,** le champ magnétique **H** généré localement par le courant d'écriture est ici horizontal dans le plan de la figure et orienté vers la gauche. La flèche verticale descendante inscrite dans le cercle magnétique symbolise l'orientation de référence de la couche ferromagnétique dure. Dans le cas de la figure 4a, l'orientation de la couche ferromagnétique douce est également verticale et descendante, puisque le dispositif est ici au repos.

Dans le cas de la figure 4b, on souhaite transporter l'information numérique «0». Pour cela, le circuit CMOS d'écriture émet un courant d'écriture $I_E$ dans la branche **341,** de manière à générer localement un champ magnétique **H** horizontal dans le plan de la figure et orienté vers l'extérieur (vers la gauche pour la partie gauche de la figure). Au niveau de l'élément magnétorésistif **353**, ce champ magnétique **H** modifie l'orientation magnétique de la couche douce, ce qui est illustré par la flèche inscrite dans le cercle orientée obliquant vers le bas et à gauche. Cet état magnétique, en combinaison avec l'état symétrique de l'élément **354** représenté sur la partie droite de la figure 4b, traduit la réception d'un « 0 ».

A l'inverse, la figure 4c représente la réception de l'information numérique «1». Pour cela, le circuit CMOS d'écriture émet un courant d'écriture dans la branche **342,** ce courant revenant par la branche **341.** Au niveau de l'élément **353** (partie gauche de la figure 4c), le champ magnétique local **H** est alors orienté horizontalement dans le plan de la figure et vers l'intérieur (vers la droite pour la partie gauche de la figure). La couche dure de référence est bien évidement toujours orientée selon la flèche verticale descendante, tandis que la couche douce est désormais orientée vers le bas et vers la droite. Cette orientation magnétique correspond à l'information numérique «1».

Ainsi, la résistance électrique des éléments **353** et **354** est différente selon qu'ils se trouvent orientés comme sur la figure 4b ou comme sur la figure 4c. De manière connue, la résistance électrique d'un empilement de couches magnétiques est donnée en première approximation (tension de polarisation faible et température ambiante) par la relation :

$$R= R_p.(1+TMR.(1-\cos \theta)/2) \qquad \qquad \textbf{[I]}$$

où :

- ■ **$R_p$.** est la résistance nominale de la jonction lorsque les aimantations des deux couches de l'empilement sont orientées dans le même sens ;
- ■ **TMR** représente la magnétorésistance tunnel, c'est-à-dire la variation relative de résistance entre les états d'orientation extrêmes ;
- ■ $\theta$ est l'angle formé entre les orientations des couches dures et douces.

Ainsi, lorsque $\theta$ vaut 0, la jonction magnétique se trouve dans un état parallèle où la résistance atteint son minimum et vaut R = Rp, tandis que lorsque $\theta = \pi$, la jonction magnétique est dans un état antiparallèle et sa résistance électrique est maximale et vaut R = Rp.(1+TMR).

Dans la forme de réalisation de l'invention illustrée par les figures 4a à 4c, l'aimantation de la couche dure (flèche verticale descendante) est orientée à 90° par rapport à l'orientation stable de la couche douce définie par son anisotropie magnétocristaline. De plus, la structure des éléments magnétorésistifs **353** et **354** est circulaire, ce qui permet d'éliminer l'effet de forme et donc de minimiser le courant d'écriture nécessaire à l'orientation magnétique de la couche douce.

Avec l'architecture illustrée par les figures 4a à 4c, l'aimantation de la couche douce fluctue autour de sa position d'équilibre (flèche verticale descendante) avec une variation angulaire maximale de 90°. Ces fluctuations relativement faibles permettent donc de limiter le courant d'écriture $I_E$ à 3 mA en valeur absolue.

Néanmoins, l'angle formé entre les orientations de la couche douce et de la couche dure de chacune des jonctions magnétiques des éléments **353** et **354** peut être modulé entre 0° et 180°. Cette amplitude de modulation permet de maximiser la variation relative de la magnétorésistance TMR (pour *Tunnel Magnetic Resistance*).

Si l'on désigne par $V_{bias}$ la tension de polarisation aux bornes des éléments **353** et **354** et compte tenu de l'expression de la résistance électrique de ces éléments (relation **I**), le différentiel de courant de lecture est exprimé par la relation :

$$\Delta i_{read} = (Vb_{ias} / R_p).(TMR / (1+TMR)) \qquad\qquad \textbf{[II]}$$

dans le cas où l'on transmet un « 0 », tandis que dans la cas où l'on transmet un « 1 », le différentiel de courant de lecture devient :

$$\Delta i_{read} = -Vb_{ias} / R_p).(TMR / (1+TMR)) \qquad\qquad \textbf{[III]}$$

Comme exposé précédemment, le circuit CMOS de lecture est apte à amplifier ce différentiel de courant de lecture $\Delta i_{read}$, puis à le convertir en une tension représentative de l'information numérique transportée « 0 » ou « 1 ».

Pour former les jonctions magnétiques décrites ici, on peut utiliser une couche d'oxyde de magnésium (MgO), permettant d'obtenir une TMR élevée, présentant une épaisseur faible dans le but d'obtenir une résistance nominale relativement faible. En l'occurrence la résistance nominale $R_p$ de l'empilement des éléments magnétorésistifs vaut environ 1Ω. Pour polariser les éléments magnétorésistifs, les électrodes **356-359** sont constituées de couches comprenant du fer, du cobalt et du bore (B) et typiquement des couches CoFe/CoFeB. Un tel empilement électrodes-jonctions donne en effet des résultats expérimentaux intéressants en termes de magnétorésistance tunnel TMR, puisque celle-ci peut atteindre 350%.

Par ailleurs, la tension de polarisation employée vaut $V_{bias}$=300 mV, ce qui permet de limiter la chute de magnétorésistance tunnel TMR, laquelle décroît avec l'augmentation de la tension de polarisation appliquée. Ainsi, le courant de lecture différentiel $\Delta i_{read}$ atteint en valeur absolue 230 µA, courant amplement suffisant pour détecter rapidement l'information numérique reçue au niveau du circuit CMOS de lecture décrit ci-après en relation avec la figure 5.

La figure 5 illustre donc un récepteur **550** composé d'un étage magnétique **551** déjà décrit et d'un circuit intégré de lecture **561** électriquement relié à l'étage magnétique **551** par l'intermédiaire de deux conducteurs **591** et **592**.

Conformément à l'invention, le circuit électronique de lecture peut être réalisé en technologie CMOS, et il associe une paire de transistors PMOS, dont les grilles sont reliées de manière à former un circuit de *«clamp », c'est à dire de limiteur de tension.* Ces deux transistors de *clamp* permettent de limiter la tension de polarisation $V_{bias}$ des jonctions magnétiques au moyen d'un réglage opéré en agissant sur la tension $V_{clamp}$ qui est appliquée sur les deux grilles.

Comme le montre la figure 5, les courants issus des drains de chacun de ces transistors PMOS sont ensuite comparés au moyen d'un miroir de courant différentiateur **563**. Pour former un tel miroir de courant différentiateur, on emploie deux transistors NMOS, dont les grilles sont portées au potentiel du drain de l'un d'entre eux de manière à générer le courant différentiel $\Delta i_{read}$ attaque le *« buffer»* ou tampon de sortie.

Selon le sens du courant circulant dans ce circuit de lecture, le miroir de courant différentiateur charge ou décharge un étage de sortie formé par un élément tampon ou « buffer » **564**. Cet élément tampon a pour rôle de régénérer l'information numérique transmise par l'émetteur en la convertissant sous la forme d'une tension compatible avec les niveaux logiques des composants CMOS constituant les éléments périphériques situés en aval du dispositif électronique objet de la présente invention. La tension générée par l'élément tampon **564** en fonction du différentiel du courant de lecture est bien évidemment représentative de l'information numérique initialement envoyée par le circuit intégré d'écriture.

La figure 6 représente une forme de réalisation du dispositif électronique objet de la présente invention, dans laquelle un émetteur **600** adresse des informations numériques identiques à plusieurs récepteurs **650, 750** et **850**. Cet adressage multiple, également connu sous le substantif anglo-saxon *« multidrop »*, est rendu possible par le fait que le courant d'écriture n'est pas influencé ni altéré par les étages magnétiques des récepteurs, si bien que le courant d'écriture peut être successivement transporté par les lignes **640, 740** et **840** etc... vers autant de récepteurs. Le seul facteur limitatif au nombre de récepteurs est la longueur de la boucle **640-740-840** que doit parcourir le courant d'écriture.

Par ailleurs, les informations numériques se propagent dans les lignes d'écriture à la vitesse de propagation de l'onde dans ces lignes, contrairement par exemple à une distribution parallèle des courants dans laquelle l'information arrive simultanément aux différents récepteurs équidistants de l'émetteur.

Ainsi, l'objet de la présente invention permet de réaliser un procédé de multi-adressage d'informations numériques de manière relativement simple, économique et faiblement consommateur d'énergie.

On notera que pour conserver une bonne immunité au bruit, il faut maintenir le plus longtemps possible la nature différentielle des liaisons entre les différents composants, ce qui nécessite une gestion du routage et des interconnexions spécifiques. Par ailleurs, il est possible de réaliser une distribution parallèle, mais cela nécessite une puissance d'écriture, donc une consommation énergétique supérieure, laquelle peut être partiellement compensée par l'utilisation de lignes de très faible impédance.

**Revendications**

1. Dispositif électronique destiné à transporter des informations numériques («0», «1») sur une longue distance, comprenant un émetteur (100-101; 201 ; 600), générant des impulsions de courant, et au moins un ensemble de moyens de réception ou récepteurs (150 ; 250 ; 650, 750, 850), convertissant les impulsions de courant reçues en impulsions logiques compatibles avec le fonctionnement des circuit électroniques logiques standards, *caractérisé en ce que* le récepteur (150 ; 250 ; 550 ; 650, 750, 850) comprend un couple d'empilements magnétorésistifs (253, 254 ; 353, 354) comportant au moins une couche ferromagnétique dure et une couche ferromagnétique douce séparées par une couche intercalaire non ferromagnétique, la couche dure de chacun des empilements magnétorésistifs (253, 254 ; 353, 354) étant piégée dans un état magnétique perpendiculaire à un axe de facile aimantation servant de référence pour la couche douce du même empilement, cette couche douce de chacun des empilements magnétorésistifs (253, 254 ; 353, 354) présentant une orientation magnétique modulable par le champ magnétique généré par les impulsions de courant issues de l'émetteur et circulant dans un conducteur (241, 242, 341, 342) situé à une distance de l'un et l'autre des empilements magnétorésistifs (253, 254 ; 353, 354) et selon une orientation choisie de manière à induire une modification de la résistance transversale de l'empilement suffisante pour déclencher un signal électrique, les modifications de résistance des deux empilements traversés par une même impulsion coopérant pour former un signal différentiel, la modulation de l'orientation magnétique de la couche douce de chaque empilement étant suffisamment faible pour que le basculement de cette orientation ne s'effectue pas entre deux positions stables mais oscille autour d'une position stable.

2. Dispositif électronique selon la revendication 1, *caractérisé en ce qu'*une impulsion de courant générée par l'émetteur fait varier d'un angle $\theta$ entre 0 et 90°, la valeur 90° n'étant jamais exactement atteinte, l'orientation magnétique de la couche douce du premier empilement, générant une variation $V_1$ dans un premier sens de la résistance transversale de ce premier empilement, et fait basculer d'un angle $\theta$ l'orientation magnétique de la couche douce du second empilement, générant une variation $V_2$ de la résistance transversale de l'empilement, $V_1$ et $V_2$ étant utilisés par un circuit de lecture donnant un signal de sortie fonction de $V_1$ - $V_2$ appelé signal différentiel.

3. Dispositif électronique selon l'une des revendications 1 et 2, *caractérisé en ce que* le ou les récepteurs (150 ; 250 ; 650) comportent des portions du conducteur (241, 242, 341, 342) en série avec l'émetteur (100-101 ; 201 ; 600), et **en ce que** l'émetteur (100-101 ; 201 ; 600) est constitué par des moyens électroniques (101 ; 201), notamment constitués par un circuit intégré, aptes à générer dans la boucle d'écriture (140 ; 240-242 ; 341-342 ; 640, 740, 840) un courant engendrant localement un champ magnétique (H) suffisant pour moduler l'orientation magnétique des couches douces.

4. Dispositif électronique selon l'une des revendications 1 à 3, *caractérisé* **en ce que** le récepteur intègre un circuit intégré électronique de lecture apte à polariser la partie magnétorésistive du récepteur et à en déterminer la résistance électrique, pour décoder les informations reçues, ledit circuit intégré étant relié électriquement aux éléments magnétorésistifs du récepteur.

5. Dispositif électronique selon l'une des revendications précédentes, *caractérisé* **en ce que** les empilements magnétorésistifs (253, 254 ; 353, 354) sont polarisés en tension au moyen d'électrodes (256-259 ; 356-359), la grandeur électrique mesurée étant constituée par la différence de courant entre lesdits éléments magnétofesistifs (253, 254 ; 353, 354).

6. Dispositif électronique selon l'une des revendications 4 et 5 *caractérisé* **en ce que** les circuits intégrés (101, 161 ; 201, 261 ; 561) de l'émetteur (100-101 ; 201 ; 600) et du récepteur (150 ; 250 ; 650, 750, 850) sont réalisés par la technologie CMOS.

7. Dispositif électronique selon l'une des revendications 1 à 6, *caractérisé* *en ce que* les couches douces des empilements magnétorésistifs du ou des récepteurs sont magnétostatiquement couplées entre elles, de telle sorte que le basculement d'une de ces couches douces induise le basculement en sens inverse de l'autre couche douce, leurs aimantations restant toujours antiparallèles.

8. Dispositif électronique selon la revendication 7, **caractérisé en ce que** les empilements magnétorésistifs (253, 254) sont placés du même côté d'un même substrat, et **en ce que** leurs couches douces est obtenue en donnant à chaque élément une géométrie en forme de C et en plaçant les deux éléments face à face, les ouvertures des deux C étant orientées l'une vers l'autre.

**9.** Dispositif électronique selon la revendication 7, *caractérisé* **en, ce que** les empilements magnétorésistifs d'un couple sont constitués par des éléments en forme de C, positionnés dans un même plan de manière à définir entre eux deux entrefers et à former essentiellement une couronne, sur l'axe de symétrie de laquelle se trouve une via (255) reliant les branches (241, 242) de la boucle d'écriture (240).

**10.** Dispositif électronique selon la revendication 7, *caractérisé* **en ce que** les empilements magnétorésistifs d'un couple sont constitués par des éléments en forme de U, positionnés dans un même plan de manière à définir entre eux deux entrefers et à former essentiellement une couronne, sur l'axe de symétrie de laquelle se trouve une via (255) reliant les branches (241, 242) de la boucle d'écriture (240).

**11.** Dispositif électronique selon la revendication 1, *caractérisé* **en ce que** les empilements magnétorésistifs (253, 254) sont placés du même côté d'un même substrat, et **en ce que** leurs couches douces est obtenue en donnant à chaque élément une géométrie en forme de U et en plaçant les deux éléments face à face, les ouvertures des deux U étant orientées l'une vers l'autre.

**12.** Dispositif électronique selon la revendication 10, *caractérisé* **en ce que** la lettre U est déformée de manière à assurer la prépondérance fonctionnelle des zones où la couche douce à une orientation magnétique antiparallèle à celle de la couche dure, ledit U étant constitué par deux branches parallèles réunies par une troisième branche perpendiculaire, dont la longueur est inférieure aux branches parallèles, et avantageusement la plus courte possible.

**13.** Dispositif électronique selon l'une des revendications 1 à 6, *caractérisé* **en ce que** les empilements magnétorésistifs (353, 354) sont constitués chacun par un plot cylindrique.

**14.** Dispositif électronique selon l'une des revendications précédentes, *caractérisé* **en ce que** les empilements magnétorésistifs (253, 254 ; 353, 354) sont constitués chacun d'une jonction magnétique à effet tunnel.

**15.** Dispositif électronique selon à la revendication 14, *caractérisé* **en ce que** les jonctions magnétiques sont réalisées en oxyde de magnésium (MgO), les électrodes étant réalisées à partir d'alliages de fer, de cobalt et/ou de bore,

**16.** Dispositif électronique selon l'une des revendications précédentes, **caractérisé en ce qu'**il comprend plusieurs récepteurs (650, 750, 850) magnétiquement couplés en série à l'émetteur (600) par l'intermédiaire d'une boucle d'écriture (640, 740, 840).

**17.** Dispositif électronique selon l'une des revendications 12 à 16, *caractérisé* **en ce que** les jonctions magnétiques présentent une magnétorésistance élevée, de préférence supérieure à 200%.


**Claims**

**1.** An electronic device designed to transport digital information ("0", "1") over long distances comprising a transmitter (100-101; 201; 600), generating current pulses and at least one assembly of means of receiving or receivers (150; 250; 650, 750, 850), converting the received current pulses into logic pulses which are compatible with the operation of standard electronic logic circuits, *characterized* **in that** the receiver (150; 250; 550; 650, 750, 850) comprises a pair of magnetoresistive stacks (253, 254; 353, 354) comprising at least one hard ferromagnetic layer and one soft ferromagnetic layer separated by a non-ferromagnetic interlayer, the hard layer of each of the magnetoresistive stacks (253, 254; 353, 354) being pinned in a magnetic orientation perpendicular to an easy-magnetization axis which is used as a reference for the soft layer of the same stack, this soft layer of each of the magnetoresistive stacks (253, 254; 353, 354) having a magnetic orientation which can be modulated by the magnetic field generated by the current pulses output by the transmitter and flowing through a conductor (241, 242, 341, 342) located in the vicinity of each of the magnetoresistive stacks (253, 254, 353, 354) with an orientation, direction and distance which are chosen so as to produce a modification in the transverse resistance of the stack which is sufficient to trigger an electrical signal, the modifications in the resistance of the two stacks through which a single pulse passes cooperating in order to form a differential signal, the modulation of the magnetic orientation of the soft layer of each stack being sufficiently small for this orientation not to reverse between two stable positions but to fluctuate around a stable position.

**2.** An electronic device as claimed in claim 1, *characterized* **in that** a current pulse generated by the transmitter causes the magnetic orientation of the soft layer of the first stack to vary by an angle $\theta$ of 0 to 90°, the precise value 90° never actually been reached, producing a variation $V_1$ in a first direction of the transverse resistance of this first stack and causing the magnetic orientation of the soft layer of the second stack to reverse by angle θ, producing a variation $V_2$ in the transverse resistance of the stack, $V_1$ and $V_2$ being used by a read circuit which delivers an output signal as a function of $V_1 - V_2$ which is referred to as a differential signal.

3. An electronic device as claimed in any of claims 1 and 2, *characterized* **in that** the receiver(s) (150; 250; 650) comprise parts of the conductor (241, 242, 341, 342) in series with the transmitter (100-101; 201; 600), and **in that** the transmitter (100-101, 201, 600) consists of electronic means (101; 201), especially consisting of an integrated circuit, capable of generating in write loop (140; 240-242; 341-342; 640, 740, 840) a current which locally generates a magnetic field (H) sufficiently strong to modulate the magnetic orientation of the soft layers.

4. An electronic device as claimed in any of claims 1 to 3, *characterized* **in that** the receiver incorporates an electronic integrated read circuit capable of biasing the magnetoresistive part of the receiver and determining its electrical resistance in order to decode received signals, said integrated circuit being electrically connected to the magnetoresistive elements of the receiver.

5. An electronic device as claimed in any of the above claims, *characterized* **in that** magnetoresistive stacks (253, 254; 353, 354) are voltage biased by means of electrodes (256-259; 356-359), the electrical quantity measured consisting of the current difference between said magnetoresistive elements (253, 254; 353, 354).

6. An electronic device as claimed in any of claims 4 and 5 *characterized* **in that** the integrated circuits (101, 161; 201, 261; 561) of the transmitter (100-101; 201; 600) and of the receiver (150; 250; 650, 750, 850) are implemented using CMOS technology.

7. An electronic device as claimed in any of claims 1 to 6, *characterized* **in that** the soft layers of the magnetoresistive stacks of the receiver(s) are magnetostatically coupled to each other so that reversal of one of these soft layers causes reversal of the other soft layer in the opposite direction, with their magnetizations always remaining anti-parallel.

8. An electronic device as claimed in claim 7, *characterized* **in that** magnetoresistive stacks (253, 254) are located on the same side of a single substrate and **in that** their soft layers are obtained by giving each element a C-shaped geometry and placing the two elements face-to-face with the openings of the Cs facing each other.

9. An electronic device as claimed in claim 7, *characterized* **in that** the magnetoresistive stacks in a pair consist of C-shaped elements positioned in the same plane so as to define, between them, two air gaps and essentially form a crown on the axis of symmetry of which there is a via (255) which links the legs (241, 242) of write loop (240).

10. An electronic device as claimed in claim 7, *characterized* **in that** the magnetoresistive stacks in a pair consist of U-shaped elements positioned in the same plane so as to define, between them, two air gaps and essentially form a crown on the axis of symmetry of which there is a via (255) which links the legs (241, 242) of write loop (240).

11. An electronic device as claimed in claim 7, *characterized* **in that** magnetoresistive stacks (253, 254) are located on the same side of a single substrate and **in that** their soft layers are obtained by giving each element a U-shaped geometry and placing the two elements face-to-face with the openings of the Us facing each other.

12. An electronic device as claimed in claim 10, *characterized* **in that** the letter U is deformed in order to ensure functional preponderance of those areas where the soft layer has a magnetic orientation which is anti-parallel to that of the hard layer, said U consisting of two parallel legs which are joined by a third perpendicular leg, the length of which is less than the parallel legs and advantageously as short as possible.

13. An electronic device as claimed in any of claims 1 to 6, *characterized* **in that** magnetoresistive stacks (353, 354) each consist of a cylindrical contact.

14. An electronic device as claimed in any of the above claims, *characterized* **in that** magnetoresistive stacks (253, 254; 353, 354) each consist of a magnetic tunnel junction.

15. An electronic device as claimed in claim 14, *characterized* **in that** the magnetic junctions are made of magnesium oxide (MgO) and the electrodes are made from alloys of iron, cobalt and/or boron.

**16.** An electronic device as claimed in any of the above claims, *characterized* **in that** it comprises several receivers (650, 750, 850) magnetically coupled in series to transmitter (600) via a write loop (640, 740, 840).

**17.** An electronic device as claimed in any of claims 12 to 16, *characterized* **in that** the magnetic junctions have a small resistance area and a high magnetoresistance, preferably in excess of 200%.


**Patentansprüche**

**1.** Elektronische Vorrichtung für den Transport von digitalen Informationen ("0", "1") auf einer langen Strecke, mit einem Stromimpulse erzeugenden Sender (100-101; 201; 600) und mindestens einer Anordnung aus Empfangsmitteln bzw. Empfängern (150; 250; 650; 750; 850), welche die empfangenen Stromimpulse in mit der Funktionsweise der logischen elektronischen Standardschaltungen kompatible logische Impulse umwandeln, **dadurch gekennzeichnet, dass** der Empfänger (150; 250; 550; 650, 750, 850) ein Paar magnetoresistiver Stapel (253, 254; 353, 354) mit mindestens einer harten ferromagnetischen Schicht und einer weichen ferromagnetischen Schicht, die durch eine nicht ferromagnetische Zwischenschicht getrennt sind, umfasst, wobei die harte Schicht des jeweiligen magnetoresistiven Stapels (253, 254; 353, 354) in einem magnetischen Zustand gefangen ist, der senkrecht zu einer Achse leichter Magnetisierung verläuft, die als Referenz für die weiche Schicht desselben Stapels dient, wobei diese weiche Schicht des jeweiligen magnetoresistiven Stapels (253, 254; 353, 354) eine magnetische Ausrichtung aufweist, die durch das Magnetfeld modulierbar ist, das durch die Stromimpulse erzeugt wird, welche aus dem Sender kommen und in einem Leiter (241, 242, 341, 342) fließen, der von dem einen und von dem anderen magnetoresistiven Stapel (253, 254; 353, 354) beabstandet ist und gemäß einer Ausrichtung angeordnet ist, die gewählt ist, um eine Änderung des Querwiderstands des Stapels zu bewirken, die ausreichend ist, um ein elektrisches Signal auszulösen, wobei die Widerstandsänderungen der zwei durch ein und denselben Impuls durchquerten Stapel zusammenwirken, um ein Differenzsignal zu bilden, wobei die Modulation der magnetischen Ausrichtung der weichen Schicht jeden Stapels ausreichend gering ist, damit das Kippen dieser Ausrichtung nicht zwischen zwei stabilen Positionen, sondern um eine stabile Position herum schwankend erfolgt.

**2.** Elektronische Vorrichtung nach Anspruch 1, **dadurch gekennzeichnet, dass** aufgrund eines durch den Sender erzeugten Stromimpulses die magnetische Ausrichtung der weichen Schicht des ersten Stapels um einen Winkel $\theta$ zwischen 0 und 90° variiert, wobei der Wert 90° nie genau erreicht wird, wodurch eine Variation $V_1$ in einer ersten Richtung des Querwiderstands dieses ersten Stapels erzeugt wird, und die magnetische Ausrichtung der weichen Schicht des zweiten Stapels um einen Winkel $\theta$ kippt, wodurch eine Variation $V_2$ des Querwiderstands des Stapels erzeugt wird, wobei $V_1$ und $V_2$ von einer Leseschaltung verwendet werden, die ein von $V_1 - V_2$ abhängiges, als Differenzsignal bezeichnetes Ausgangssignal ausgibt.

**3.** Elektronische Vorrichtung nach einem der Ansprüche 1 und 2, **dadurch gekennzeichnet, dass** der oder die Empfänger (150; 250; 650) Abschnitte des Leiters (241, 242, 341, 342) aufweisen, die mit dem Sender (100-101; 201; 600) seriengeschaltet sind, und dass der Sender (100-101; 201; 600) durch elektronische Mittel (101; 201) gebildet ist, die insbesondere durch eine integrierte Schaltung gebildet sind und geeignet sind, in der Schreibschleife (140; 240-242; 341-342; 640; 740; 840) einen Strom zu erzeugen, der lokal ein für die Modulation der magnetischen Ausrichtung der weichen Schichten ausreichendes Magnetfeld (H) erzeugt.

**4.** Elektronische Vorrichtung nach einem der Ansprüche 1 bis 3, **dadurch gekennzeichnet, dass** der Empfänger eine elektronische integrierte Leseschaltung umfasst, die geeignet ist, den magnetoresistiven Teil des Empfängers zu polarisieren und dessen elektrischen Widerstand zu bestimmen, um die empfangenen Informationen zu dekodieren, wobei die integrierte Schaltung elektrisch mit den magnetoresistiven Elementen des Empfängers verbunden ist.

**5.** Elektronische Vorrichtung nach einem der vorhergehenden Ansprüche, **dadurch gekennzeichnet, dass** die magnetoresistiven Stapel (253, 254; 353, 354) mittels Elektroden (256-259; 356-359) spannungspolarisiert sind, wobei die elektrische Messgröße durch die Stromdifferenz zwischen den magnetoresistiven Elementen (253, 254; 353, 354) gebildet ist.

**6.** Elektronische Vorrichtung nach einem der Ansprüche 4 und 5, **dadurch gekennzeichnet, dass** die integrierten Schaltungen (101, 161; 201, 261; 561) des Senders (100-101; 201; 600) und des Empfängers (150; 250; 650, 750, 850) in der CMOS-Technologie hergestellt sind.

**7.** Elektronische Vorrichtung nach einem der Ansprüche 1 bis 6, **dadurch gekennzeichnet, dass** die weichen Schichten der magnetorisistiven Stapel des oder der Empfänger magnetostatisch miteinander gekoppelt sind, so dass das Kippen einer dieser weichen Schichten das entgegengesetzte Kippen der anderen weichen Schicht bewirkt, wobei deren Magnetisierungen immer antiparallel bleiben.

8. Elektronische Vorrichtung nach Anspruch 7, **dadurch gekennzeichnet, dass** die magnetoresistiven Stapel (253, 254) auf derselben Seite ein und desselben Substrats angeordnet sind und dass deren weiche Schichten dadurch erzielt werden, dass jedem Element eine C-förmige Geometrie verliehen wird und die zwei Elemente einander gegenüber angeordnet werden, wobei die Öffnungen der beiden C zueinander gerichtet sind.

9. Elektronische Vorrichtung nach Anspruch 7, **dadurch gekennzeichnet, dass** die magnetoresistiven Stapel eines Paars durch C-förmige Elemente gebildet sind, die in ein und derselben Ebene derart angeordnet sind, dass dazwischen zwei Luftspalte definiert werden und im Wesentlichen ein Kranz gebildet wird, auf dessen Symmetrieachse sich eine Durchkontaktierung (255) befindet, welche die Schenkel (241, 242) der Schreibschleife (240) verbindet.

10. Elektronische Vorrichtung nach Anspruch 7, **dadurch gekennzeichnet, dass** die magnetoresistiven Stapel eines Paars durch U-förmige Elemente gebildet sind, die in ein und derselben Ebene derart angeordnet sind, dass dazwischen zwei Luftspalte definiert werden und im Wesentlichen ein Kranz gebildet wird, auf dessen Symmetrieachse sich eine Durchkontaktierung (255) befindet, welche die Schenkel (241, 242) der Schreibschleife (240) verbindet.

11. Elektronische Vorrichtung nach Anspruch 7, **dadurch gekennzeichnet, dass** die magnetoresistiven Stapel (253, 254) auf derselben Seite ein und desselben Substrats angeordnet sind und dass deren weiche Schichten dadurch erzielt werden, dass jedem Element eine U-förmige Geometrie verliehen wird und die zwei Elemente einander gegenüber angeordnet werden, wobei die Öffnungen der beiden U zueinander gerichtet sind.

12. Elektronische Vorrichtung nach Anspruch 10, **dadurch gekennzeichnet, dass** der Buchstabe U derart verformt ist, dass die funktionale Dominanz der Bereiche gewährleistet ist, in denen die weiche Schicht eine magnetische Ausrichtung aufweist, die antiparallel zu derjenigen der harten Schicht ist, wobei das U durch zwei parallele Schenkel gebildet ist, die durch einen dritten senkrechten Schenkel verbunden sind, dessen Länge kleiner als die parallelen Schenkel und vorteilhafterweise so klein wie möglich ist.

13. Elektronische Vorrichtung nach einem der Ansprüche 1 bis 6, **dadurch gekennzeichnet, dass** die magnetoresistiven Stapel (353, 354) jeweils durch ein zylindrisches Plättchen gebildet sind.

14. Elektronische Vorrichtung nach einem der vorhergehenden Ansprüche, **dadurch gekennzeichnet, dass** die magnetoresistiven Stapel (253, 254; 353, 354) jeweils durch eine magnetische Tunnelverbindung gebildet sind.

15. Elektronische Vorrichtung nach Anspruch 14, **dadurch gekennzeichnet, dass** die magnetischen Verbindungen aus Magnesiumoxid (MgO) hergestellt sind, wobei die Elektroden aus Eisen-, Kobalt- und/oder Borlegierungen hergestellt sind.

16. Elektronische Vorrichtung nach einem der vorhergehenden Ansprüche, **dadurch gekennzeichnet, dass** sie mehrere Empfänger (650, 750, 850) umfasst, die über eine Schreibschleife (640, 740, 840) magnetisch mit dem Sender (600) seriengeschaltet sind.

17. Elektronische Vorrichtung nach einem der Ansprüche 12 bis 16, **dadurch gekennzeichnet, dass** die magnetischen Verbindungen einen hohen magnetischen Widerstand aufweisen, der vorzugsweise über 200 % liegt.

**Fig. 1**

**Fig. 2A**

**Fig. 2B**

**Fig. 3A**

241

-251-

257

256

258

253

254

259

255

242

291

292

**Fig. 3B**

353

356

357

358

354

341

342

359

391

392

**Fig. 4A**

-355-

358

359

341

342

**Fig. 4B**

H

H

$I_E$

**Fig. 4C**

H

H

$I_E$

**Fig. 5**

**Fig. 6**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

*   WO 03088283 A